# EUROPÄISCHE PATENTSCHRIFT

(11) **EP 3 185 655 B1**
(45) Veröffentlichungstag und Bekanntmachung des Hinweises auf die Patenterteilung: **29.11.2023**
(21) Anmeldenummer: 16205606.3
(22) Anmeldetag: 21.12.2016
(51) Int. Cl.: H05K 1/02, H05K 1/03, H05K 3/00, H05K 3/02

(54) **VERFAHREN ZUR INDIVIDUELLEN CODIERUNG VON METALL-KERAMIK-SUBSTRATEN**
METHOD FOR THE INDIVIDUAL ENCODING OF METAL-CERAMIC SUBSTRATES
PROCÉDÉ DE CODAGE INDIVIDUEL DE SUBSTRATS MÉTAL-CÉRAMIQUES

(30) Priorität: 22.12.2015 EP 15201883
(43) Veröffentlichungstag der Anmeldung: 28.06.2017
(73) Patentinhaber: Heraeus Deutschland GmbH & Co. KG, 63450 Hanau (DE)
(72) Erfinder: Wacker, Richard, 96135 Stegaurach (DE); Rogg, Alexander, 92724 Trabitz (DE)
(74) Vertreter: Gille Hrabal Partnerschaftsgesellschaft mbB Patentanwälte

(56) Entgegenhaltungen:
- WO-A1-03/078353
- DE-A1- 3 113 031
- DE-C1- 19 829 986
- GB-A- 2 343 059
- US-A1- 2009 223 435

## Beschreibung

Die vorliegende Erfindung betrifft ein Verfahren zur individuellen Codierung von Metall-Keramik-Substraten. Weiterer Gegenstand der vorliegenden Erfindung sind Metall-Keramik-Substrate, die eine individuelle Markierung aufweisen.

Metall-Keramik-Substrate bzw. Keramiksubstrate mit Metallisierungen sind in verschiedensten Ausführungen bekannt, insbesondere als Leiterplatten oder Substrate für elektrische und elektronische Schaltkreise. Im Rahmen dieser hochspeziellen Anwendungen hat die Möglichkeit der Rückverfolgung für Abnehmer entsprechender Metall-Keramik-Substrate in den letzten Jahren zunehmend an Bedeutung gewonnen. Zur Rückverfolgung von Metall-Keramik-Substraten eignen sich grundsätzlich individuelle Codierungen auf dem Keramiksubstrat oder der Metallbeschichtung.

Metall-Keramik-Substrate, beispielsweise DCB-Substrate, werden üblicherweise mittels Fotolithographie strukturiert. Hierbei wird eine lichtempfindliche Folie (Trockenfilm oder Laminat) auf das Metall-Keramik-Substrat laminiert und mit einem fotographischen Negativ abgedeckt. Anschließend werden mit einer starken Lichtquelle alle Bereiche des Laminats belichtet, die nicht durch den fotographischen Negativ abgedeckt sind. Die abgedeckten und damit nicht-belichteten Bereiche werden im nachfolgenden Entwicklungsschritt herausgelöst. Das darunter liegende Metall wird freigelegt und im abschließend Verfahrensschritt durch Ätzen herausgelöst und damit entfernt. Anschließend werden die noch verbliebenen Bereiche der lichtempfindlichen Folie entfernt.

Bei diesem herkömmlichen Strukturierungsschritt wird ein Film verwendet, dessen Layout für alle mit diesem Film belichteten Metall-Keramik-Substrate identisch ist. Daher weisen alle strukturierten Metall-Keramik-Substrate dasselbe Layout auf und eine individualisierte Codierung der einzelnen Metall-Keramik-Substrate ist nicht ohne weiteres möglich.

Eine weitere Möglichkeit, eine individuelle Codierung auf einem Metall-Keramik-Substrat vorzusehen, ist in der EP 1 487 759 A beschrieben. In diesem Verfahren wird zunächst eine Metallfolie auf ein Keramiksubstrat mithilfe der bekannten DCB-Technologie gebondet. Im Anschluss an diesem Bondprozess kann vor oder nach der Strukturierung der Metallfolie ein Lötstopplack auf die Metallschicht aufgebracht werden. In diesen Lötstopplack kann dann durch geeignete Technologien, die in der EP 1 487 759 A nicht weiter beschrieben werden, eine optisch sichtbare Struktur in Form eines Barcode oder eines Datamatrix-Codes eingebracht werden. Nachteilig an dem Verfahren gemäß EP 1 487 759 A ist jedoch, dass zur Erzeugung einer entsprechenden optisch sichtbaren Struktur zunächst der Auftrag eines Lötstopplackes erforderlich ist, der dann in einem weiteren nachgelagerten Verfahrensschritt noch einer Strukturierung unterworfen werden muss. Das somit erhaltene Verfahren gemäß EP 1 487 759 A ist somit technisch aufwendig und unter Kostengesichtspunkten nachteilig.

US 2009/0223435 A offenbart ein PCB-System, welches ID-Markierungen umfasst, die während der Herstellung des PCB-Systems durch Ätzen der Kupferfolie entstehen. Das Verfahren, welches in der genannten US-Patentanmeldung beschrieben wird, scheint nicht geeignet zu sein, DCB-, DAB- oder AMB-Systeme beidseitig zu strukturieren oder zu markieren. Das gleiche gilt für Metall-Keramik-Substrate, die zwischen dem Keramik-Substrat und der Metallschicht eine Schicht einer Dickfilmpaste umfassen, wie insbesondere in der nicht vorveröffentlichten europäischen Patentanmeldung mit dem Aktenzeichen EP 15 201 817.2 mit dem Titel "Thick-film paste mediated ceramics bonded with metal or metal hybrid foils" beschrieben.

Ein ähnliches Verfahren ist für PCB-Systeme in GB 2 343 059 A beschrieben.

DE 31 13 031 A beschreibt ein Verfahren zur Herstellung von Leiterplatten, bei welchen die Leiterplatten auf dem Rand des Mehrfachnutzens eine individuelle Codierung aufweisen.

Es besteht Bedarf nach einem einfachen und kostengünstigen Verfahren zur Bereitstellung von Metall-Keramik-Substraten, mit welchem eine individualisierte Markierung von einzelnen Metall-Keramik-Substraten möglich ist (individualisierte Codierung). Unter einer individuellen Codierung wird dabei im Rahmen der vorliegenden Erfindung eine Markierung verstanden, die für jedes Metall-Keramik-Substrat unterschiedlich sein kann und damit eine Rückverfolgung, einerseits während des Herstellprozesses und andererseits nach dem Herstellprozess, der einzelnen Metall-Keramik-Substrate ermöglicht.

Zur Lösung dieser Aufgabenstellung schlägt die vorliegende Erfindung ein Verfahren zur Herstellung von Metall-Keramik-Substraten vor, bei welchem die Strukturierung durch ein Direktbelichtungsverfahren (Direct Imaging (DI)) erfolgt. Bei dem Direktbelichtungsverfahren (DI) wird das Layout der Metallbeschichtung nicht mehr als Abbild einer Filmvorlage auf einen lichtsensiblen Film auf das Metall-Keramik-Substrat erzeugt, sondern die Strukturen werden beispielsweise mit einem digital gesteuerten Laser (Laser Direct Imaging (LDI)), mehreren Lasern sequentiell oder einem Projektor auf die lichtempfindliche Folie aufgebracht. Die Quelle dafür sind beispielsweise Laserdioden, deren gebündeltes Licht von digital gesteuerten Linsen oder speziellen Optiksystemen ausgelenkt wird. Die nicht-belichteten Bereiche werden im nachfolgenden Entwicklungsschritt herausgelöst, das darunter liegende Metall freigelegt und im abschließenden Verfahrensschritt durch Ätzen herausgelöst und damit entfernt. Anschließend werden die noch verbliebenen Bereiche der lichtempfindlichen Folie entfernt. Alternativ ist es auch möglich, dass die belichteten Bereiche im nachfolgenden Entwicklungsschritt herausgelöst und damit entfernt werden, das darunterliegende Metall freigelegt und dem abschließenden Verfahrensschritt durch Ätzen herausgelöst wird.

Das Verfahren der Direktbelichtung kann bei der Herstellung von PCB-Systemen (Printed Circuit Board) angewendet werden. Im Gegensatz hierzu sieht die vorliegende Erfindung insbesondere die Verarbeitung von DCB-Substraten (DCB = direct copper bonding), DAB-Substraten (DAB = direct aluminum bonding) oder AMB-Substraten (AMB = active metal brazing) vor, die in der Regel eine beidseitige Metallbeschichtung aufweisen. Das gleiche gilt für Das gleiche gilt für Metall-Keramik-Substrate, die zwischen dem Keramik-Substrat und der Metallschicht eine Schicht einer Dickfilmpaste umfassen, wie insbesondere in der nicht vorveröffentlichten europäischen Patentanmeldung mit dem Aktenzeichen EP 15 201 817.2 mit dem Titel "Thick-film paste mediated ceramics bonded with metal or metal hybrid foils" beschrieben. Bisher sind keine Vorrichtungen bekannt, die beide Seiten der Substrate gleichzeitig belichten. Bei einem Belichtungsprozess durch die Direktbelichtung in 2 Stufen (Direktbelichtung der Vorderseite und dann Direktbelichtung der Rückseite) ist der Layoutversatz von Vorder- zu Rückseite sehr stark abhängig von der Genauigkeit der Positionserkennung des Substrates, was das Verfahren der Direktbelichtung in einem beidseitigen Strukturierungsprozess von entsprechenden Substraten erschwert oder bisher nicht ermöglicht.

Durch geeignete Prozessführung lassen sich dabei die zu verarbeitenden bzw. fertiggestellten Metall-Keramik-Substrate individuell codieren und eine Nachverfolgbarkeit der einzelnen Metall-Keramik-Substrate ist gegeben.

Die vorliegende Erfindung löst die zuvor beschriebenen Nachteile des Standes der Technik in einem ersten Aspekt durch ein Verfahren zur Herstellung von Metall-Keramik-Substraten gemäß Anspruch 1.

Im Rahmen der vorliegenden Erfindung werden die folgenden Begrifflichkeiten verwendet: Unter einem Layout versteht man jedwede Ätzung der Metallschicht des Metall-Keramik-Substrats, die entweder auf die Erzeugung von einer individuellen Markierung des Metall-Keramik-Substrats (Codierung) oder auf die Erzeugung von elektronischen Strukturen auf dem Metall-Keramik-Substrat (Strukturierung) zurückzuführen sind.

Die erfindungsgemäßen Verfahrensschritte b. und c. können entweder nacheinander in beliebiger Reihenfolge oder auch in einem einzigen Verfahrensschritt durchgeführt werden,
In dem erfindungsgemäßen Verfahren wird von einem unstrukturierten Metall-Keramik-Substrat ausgegangen. Hierbei kann es sich beispielswiese um ein DCB-Substrat (DCB = direct copper bonding) handeln. Weitere mögliche Substrate sind DAB-Substrate (DAB = direct aluminum bonding) oder AMB-Substrate (AMB = active metal brazing). Des Weiteren kann es sich um ein Metall-Keramik-Substrat handeln, das zwischen dem Keramik-Substrat und der Metallschicht eine Schicht einer Dickfilmpaste umfasst, wie insbesondere in der nicht vorveröffentlichten europäischen Patentanmeldung mit dem Aktenzeichen EP 15 201 817.2 mit dem Titel "Thick-film paste mediated ceramics bonded with metal or metal hybrid foils" beschrieben. Das unstrukturierte Metall-Keramik-Substrat kann eine Metallbeschichtung auf einer Seite des Keramik-Substrats oder auf beiden Seiten des Keramik-Substrats aufweisen. Bevorzugt weist das Keramik-Substrat eine Metallbeschichtung auf beiden Seiten auf und das Layout wird auf beiden Seiten des Keramik-Substrats erzeugt.

Verfahren zur Herstellung entsprechender Metall-Keramik-Substrate sind dem Fachmann hinlänglich bekannt.

Das erfindungsgemäße Verfahren sieht im Verfahrensschritt b. eine Strukturierung zumindest einer Metallbeschichtung des Keramik-Substrats vor. Das zu erzeugende Layout der Strukturierung liegt im erfindungsgemäßen Verfahren vor der Strukturierung im Verfahrensschritt b. vorzugsweise in einer Datenbank vor und ist in der Datenbank dem zu strukturierenden Metall-Keramik-Substrat zugeordnet. Hierfür ist es erforderlich, dass das unstrukturierte Metall-Keramik-Substrat in der Datenbank hinterlegt ist oder wird.

Grundsätzlich können in dem erfindungsgemäßen Verfahren im Verfahrensschritt a. unstrukturierte Metall-Keramik-Substrate eingesetzt werden, die bereits eine erste individualisierte Codierung aufweisen. Falls ein Metall-Keramik-Substrat mit erster individualisierter Codierung verwendet wird, befindet sich die Codierung auf dem Keramik-Substrat und nicht auf der Metallbeschichtung, so dass die gesamte Fläche der Metallbeschichtung für die anschließende Strukturierung verwendet werden kann.

Die erste individualisierte Codierung kann jede optisch erkennbare Codierung sein und kann auf dem unstrukturierten Keramik-Substrat vorzugsweise mit einem Farbstoff, beispielsweise einer Tinte, einer Metallpaste oder durch Markieren mittels Laser (unter Erzeugung einer optisch erkennbaren Codierung) erzeugt sein.

Üblicherweise werden Metall-Keramik-Substrate im sogenannten Mehrfachnutzen hergestellt, worunter man solche Metall-Keramik-Substrate versteht, die beispielsweise ein Format von 178 mm x 127 mm oder größer aufweisen und zumindest an einer Oberflächenseite der Keramikschicht, vorzugsweise aber an beiden Oberflächenseiten der Keramikschicht, Einzelmetallisierungen besitzen, zwischen denen Sollbruchlinien in der Keramikschicht verlaufen, so dass durch Brechen entlang dieser Sollbruchlinien das großflächige Metall-Keramik-Substrat in Einzelsubstrate getrennt werden kann, die dann jeweils die Leiterplatte eines Schaltkreises oder Moduls bilden können.

Solche als Mehrfachnutzen ausgebildete Metall-Keramik-Substrate weisen aufgrund ihrer Größe im Allgemeinen einen Stützrand an der Keramik auf, über welche die einzelnen Metall-Keramik-Substrate miteinander verbunden sind und der am Ende des Verfahrens verworfen wird. Falls ein entsprechender Stützrand Anwendung findet, wird die erste individualisierte Codierung vorzugsweise auf dem Stützrand angebracht.

Unabhängig von der Position der ersten individualisierten Codierung, d.h. auf dem Keramik-Substrat selbst oder auf dem Stützrand beim Mehrfachnutzen, wird die erste individualisierte Codierung, falls vorhanden, durch eine optische Kamera erfasst.

Nach Erfassung der ersten individualisierten Codierung kann im Rahmen des erfindungsgemäßen Verfahrens auf einen der Codierung zugeordneten Datensatz für das entsprechende Metall-Keramik-Substrat (oder dem Verbund von Metall-Keramik-Substraten im Mehrfachnutzen) in einer Datenbank zurückgegriffen werden oder es kann in einer Datenbank auf Basis der ersten individualisierten Codierung ein Datensatz für das entsprechende Metall-Keramik-Substrat (oder dem Verbund von Metall-Keramik-Substraten im Mehrfachnutzen) erzeugt werden.

Dieser Datensatz umfasst insbesondere Informationen über die im Verfahrensschritt b. durchzuführende Strukturierung der Metallschicht (Erzeugung von elektronischen Strukturen). Sollte eine Strukturierung der Metallbeschichtung auf der Vorder- und Rückseite des Keramik-Substrats vorgesehen sein, umfasst der Datensatz Informationen über die zu erzeugende Strukturierung auf beiden Seiten des Keramik-Substrats zur Bildung von elektronischen Strukturen.

Die in dem Datensatz vorhandenen Informationen über die Strukturierung werden dann später im Verfahrensschritt b. verwendet, um mittels insbesondere Direktbelichtung (*direct imaging*) eine Strukturierung der lichtempfindlichen Folie und anschließend der Metallschicht zu erreichen.

Zu der ersten individualisierten Codierung auf dem Keramik-Substrat, die durch die Kamera erfasst wird, sind in einer Datenbank vorzugsweise weitere Informationen über das unstrukturierte Metall-Keramik-Substrat abgelegt oder werden nach Einlesen der ersten individualisierten Codierung und Aufnahme in die Datenbank abgelegt.

Weitere Informationen über das unstrukturierte Metall-Keramik-Substrat, die entweder bereits in der Datenbank abgelegt worden sind oder nach Erzeugung des Datensatzes abgelegt werden, können beispielsweise ausgewählt werden aus der Gruppe, bestehend aus Chargennummer des unstrukturierten Metall-Keramik-Substrats, Herstellungsdatum, verwendeten Materialien für das Keramik-Substrat, verwendeten Materialien für die Metallbeschichtung, Ausmaß des Keramik-Substrats, Ausmaß der Metallbeschichtung, Informationen über die Herstellung des unstrukturierten Metall-Keramik-Substrats, beliebige Kundeninformationen, Informationen über Materialfehler, bspw. Informationen über Gaseinschlüsse zwischen Metallbeschichtung und Keramik (Lunker), und jegliche Kombinationen der vorstehenden Informationen.

Im Verfahrensschritt b. erfolgt die Strukturierung des Metall-Keramik-Substrates durch Direktbelichtung (*direct imaging*)*.* Bei dem Verfahren der Direktbelichtung wird eine photosensitive Schicht auf der Metallbeschichtung des unstrukturierten Metall-Keramik-Substrats aufgetragen. Danach wird beim sogenannten *laser direct imaging* (LDI) ein Laserstrahl dorthin projiziert, wo anschließend die Metallbeschichtung erhalten bleiben soll. Der Laserstrahl kann durch einen digital gesteuerten Laser, mehreren Lasern sequentiell oder einem Projektor auf die lichtempfindliche Folie aufgebracht werden. Die Quelle dafür sind beispielsweise Laserdioden, deren gebündeltes Licht von digital gesteuerten Linsen oder speziellen Optiksystemen ausgelenkt wird. Die nicht-belichteten Bereiche werden im nachfolgenden Entwicklungsschritt herausgelöst, das darunter liegende Metall freigelegt und im abschließend Verfahrensschritt durch Ätzen herausgelöst und damit entfernt. Anschließend werden die noch verbliebenen Bereiche der lichtempfindlichen Folie entfernt. Auch eine umgekehrte Verfahrensweise, bei welcher der Laserstrahl des *laser direct imaging* dort hingerichtet wird, wo anschließend die Metallbeschichtung entfernt werden soll, ist möglich.

Neben diesem Verfahren der Direktbelichtung zur Erzeugung des Layouts des zu strukturierenden Metall-Keramik-Substrates wird in dem Verfahrensschritt c. das Metall-Keramik-Substrat mit einer zweiten individualisierten Codierung auf der Metallschicht versehen. Diese zweite individualisierte Codierung erfolgt in der Metallbeschichtung des Metall-Keramik-Substrats. In dem Fall einer beidseitigen Metallbeschichtung kann die zweite individualisierte Codierung nur auf einer Seite oder auf beiden Seiten des Keramik-Substrats erfolgen. Die zweite individualisierte Codierung wird in die Metallbeschichtung ebenfalls durch ein wie vorstehend bereits beschriebenes Direktbelichtungsverfahren aufgebracht und hierzu wird die gleiche Vorrichtung, vorzugsweise der gleiche Laser oder Projektor, wie für die Strukturierung im Verfahrensschritt b. verwendet. Die Verfahrensschritte b. und c. des erfindungsgemäßen Verfahrens können in einer beliebigen Reihenfolge nacheinander oder gleichzeitig durchgeführt werden.

Daher ist es in einer bevorzugten Ausführungsform der vorliegenden Erfindung möglich, dass die beiden Verfahrensschritte b. und c. in einem einzigen Verfahrensschritt im Rahmen des erfindungsgemäßen Verfahrens verwirklicht sind.

In dem Fall, in welchem eine Mehrzahl an Metall-Keramik-Substraten verwendet werden, die über einen Stützrand miteinander verbunden sind, wird eine zweite individualisierte Codierung im Verfahrensschritt c. vorzugsweise auf der Metallschicht eines jeden einzelnen Metall-Keramik-Substrats erzeugt.

In dem Fall einer beidseitigen Metallbeschichtung kann die zweite individualisierte Codierung auf der Metallschicht auf der Vorderseite oder der Metallbeschichtung der Rückseite des Metall-Keramik-Substrates im Verfahrensschritt c. erzeugt werden. Auch eine beidseitige Codierung, d.h. eine identische oder unterschiedliche Codierung auf beiden Seiten des Metall-Keramik-Substrats, ist möglich.

Wenn die zweite individualisierte Codierung, beispielsweise in Form eines Strichcodes oder einer Datamatrix, in der Metallbeschichtung durch eine Direktbelichtung erfolgt, beträgt die erzeugte Ätztiefe üblicherweise 25 bis 75% der Dicke der Metallschicht. Andere Formen eines Codes, beispielsweise an definierten Stellen freigeätzte Flächen, beispielsweise als runde oder eckige Fläche, werden üblicherweise bis zur Keramik weggeätzt. Diese individualisierten Codierungen dienen beispielsweise dazu, insbesondere im Verbund des Mehrfachnutzens vorliegende fehlerhafte Einzel-Metall-Keramik-Substrate, zu kennzeichnen. Bei den fehlerhaften Einzel-Metall-Keramik-Substraten kann es sich insbesondere um Einzel-Metall-Keramik-Substrate handeln, die Lunker, d.h. Gaseinschlüsse zwischen Metallschicht und Keramik-Substrat, aufweisen.

Im Folgenden werden bevorzugte Ausgestaltungen der individualisierten Codierungen beschreiben, die sowohl für die erste individualisierte Codierung als auch für die zweite individualisierte Codierung gelten:
in einer ersten Ausgestaltung kann die erste und/oder zweite individualisierte Codierung aus Pixeln der Größe 40 bis 150 µm, weiter bevorzugt 50 bis 120 µm, noch weiter bevorzugt 60 bis 100 µm, gebildet werden.

In einer zweiten Ausgestaltung kann die Größe der ersten individualisierte Codierung auf dem Keramik-Substrat und/oder die Größe der zweiten individualisierten Codierung auf der Metallschicht 240 bis 3600 µm², weiter bevorzugt 300 bis 2900 µm², noch weiter bevorzugt 600 bis 2400 µm², betragen.

In einer dritten Ausgestaltung können die erste individualisierte Codierung auf dem Keramik-Substrat und/oder die zweite individualisierte Codierung auf der Metallschicht als Strichcode oder 2D-Code ausgebildet sein.

Alternativ oder ergänzend ist es möglich, dass die erste individualisierte Codierung und/oder die zweite individualisierte Codierung eine Form eines Codes aufweist, der auslesbar und/oder visuell erkennbar ist. Mögliche Formen eines Codes sind beispielweise geometrische Formen, wie eine runde, eckige und/oder freiförmige Fläche, oder geometrische Figuren wie bspw. ein Kreis, Rechteck, Quadrat, Dreieck usw. Alternativ oder ergänzend ist es möglich, dass die Form des Codes eine Kombination aus geometrischer Form und geometrischer Figur ist, so dass beispielsweise ein Kreuz, ein X oder dergleichen möglich ist. Alternativ oder ergänzend ist es möglich, dass die zweite individualisierte Codierung auf dem Keramik-Substrat ausgebildet ist.

In einervierten Ausgestaltung ist es möglich, dass die jeweilige Codierung an einer bestimmten Stelle auf dem Metall-Keramik-Substrat aufgebracht ist. Möglich ist beispielweise der untere, linke Eckbereich eines Metall-Keramik-Substrates. Eine beliebige andere Position ist alternativ oder ergänzend möglich.

In einerfünften Ausgestaltung kann die zweite individualisierte Codierung nur aus einer freigeätzen beliebigen geometrischen Figur (Kreis, Rechteck, Quadrat, Dreieck etc.) bestehen und kennzeichnet damit ein fehlerhaftes Metall-Keramik-Substrat.

In dem Fall, dass die zweite individualisierte Codierung auf der Metallschicht als Strichcode ausgebildet ist können die dunklen Bereiche des Strichcodes geätzt sein und die hellen Bereiche des Strichcodes auf der Metallschicht durch das Metall ausgebildet sein.

In dem Fall, dass die zweite individualisierte Codierung auf der Metallschicht als Strichcode ausgebildet ist können die hellen Bereiche des Strichcodes geätzt sein und die dunklen Bereiche des Strichcodes durch das Metall ausgebildet sein.

In einer sechsten Ausgestaltung können die erste individualisierte Codierung auf dem Keramik-Substrat und/oder die zweite individualisierte Codierung auf der Metallschicht als Strichcode ausgebildet sein und der Strichcode kann durch äquidistante Metallflächen gebildet sein.

In einer siebten Ausgestaltung können die erste individualisierte Codierung auf dem Keramik-Substrat und/oder die zweite individualisierte Codierung auf der Metallschicht als Datamatrix-Codierung ausgebildet sein.

In einer weiteren Ausgestaltung des erfindungsgemäßen Verfahrens kann zwischen dem Verfahrensschritt a. und dem Verfahrensschritt b. an dem unstrukturierten Metall-Keramik-Substrat eine Ultraschall-Untersuchung oder eine andere geeignete Analyse der Metallbeschichtung durchgeführt werden, um Bereiche auf dem unstrukturierten Metall-Keramik-Substrat zu identifizieren, in denen Gaseinschlüsse zwischen Keramik und Metall (sogenannte Lunker) vorliegen.

Diese Lunker sind in der Regel in der weiteren Prozessierung der Metall-Keramik-Substrate nachteilig und müssen bisher üblicherweise manuell identifiziert und markiert werden. Das erfindungsgemäße Verfahren sieht hierzu eine automatisierte Erkennung der Lunker vor. Die dabei festgestellt Lunkerposition auf der Metallbeschichtung wird dann in den zugrundeliegenden Datensatz des Metall-Keramik-Substrats eingelesen. In der nachfolgenden Strukturierung wird dann das Layout dergestalt angepasst, dass die Lunkerposition derart belichtet wird, dass die entsprechende Metallbeschichtung an dieser Position geätzt wird, was zu einem Entfernen der Lunker führt. Alternativ kann somit durch Freiätzen einer definierten Stelle auf dem Metall-Keramik-Einzelsubstrat das Metall-Keramik-Einzelsubstrat als fehlerhaft gekennzeichnet werden.

Im Rahmen des erfindungsgemäßen Verfahrens werden in der Regel Lunker typischerweise nur berücksichtigt, wenn sie eine Mindestgröße (größte Ausdehnung auf einer Linie) im Bereich von 0,5 bis 3 mm aufweisen.

Darüber hinaus betrifft die vorliegende Erfindung auch unabhängig von der individuellen Codierung des unstrukturierten Metall-Keramik-Substrats und/oder des strukturierten Metall-Keramik-Substrats ein Verfahren zur Identifizierung und Beseitigung von Gaseinschlüssen, die sich zwischen dem Keramiksubstrat und der Metallbeschichtung beim Bondprozess ergeben können.

Zu diesem Zwecke wird das gebondete Metall-Keramik-Substrat, wie oben bereits dargestellt, mittels Ultraschall-Untersuchung oder anderer geeigneter Analyseverfahren untersucht, um die Position des Lunkers auf dem Metall-Keramik-Substrat zu identifizieren. Im Anschluss wird die Position des Lunkers dergestalt mit Hilfe der Direktbelichtung einer Strukturierung unterworfen, dass an der Stelle des Lunkers die Metallbeschichtung und damit der Gaseinschluss entfernt werden. Dieses Verfahren der Identifizierung und Beseitigung von Gaseinschlüssen kann ferner so durchgeführt werden, dass die Position des Lunkers nach Erkennung in eine Datenbank (zu dem entsprechenden Datensatz des Metall-Keramik-Substrats) übertragen wird und der entsprechende Datensatz bei der Steuerung der Direktbelichtung berücksichtigt wird.

Im Hinblick auf die genaue Durchführung der Direktbelichtung wird auf obige Ausführungen verwiesen.

In einer weiteren Ausführungsform betrifft die vorliegende Erfindung auch unstrukturierte Metall-Keramik-Substrate mit einer auf das Keramik-Substrat aufgebrachten individuellen Codierung. Für genaue Ausgestaltungen wird auf die obigen Ausführungen verwiesen.

In einer weiteren Ausführungsform betrifft die vorliegende Erfindung auch strukturierte Metall-Keramik-Substrate mit einer auf die Metallbeschichtung aufgebrachten Codierung. Für genaue Ausgestaltungen wird auf die obigen Ausführungen verwiesen.

Die vorliegende Erfindung wird anhand der nachfolgenden Figur des erfindungsgemäßen Verfahrens näher verdeutlicht.

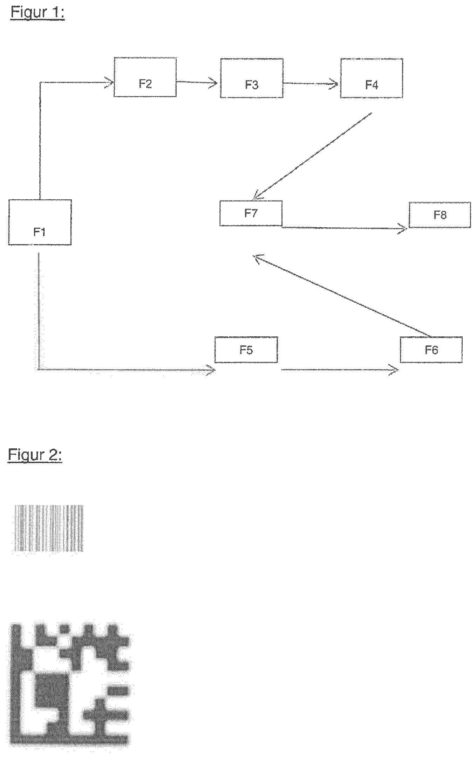

Die Figur 1 zeigt ein Fließschema des erfindungsgemäßen Verfahrens. In dieser Figur weisen die Bezugszeichen die folgende Bedeutung auf:
- F1:: Bereitstellen eines unstrukturierten Metall-Keramik-Substrates mit einer photosensitiven Schicht, wobei die photosensitive Schicht und die darunter vorgesehene Metallschicht auf einer Seite der Keramik oder auf beiden Seiten der Keramik vorgesehen ist
- F2:: Erkennen einer ersten individualisierten Codierung auf dem Keramik-Substrat
- F3:: Laden von Informationen über das zu erzeugenden Layout auf der Metallbeschichtung des Keramik-Substrats (gegebenenfalls auch für beide Seiten der Metallbeschichtung)
- F4:: Übermitteln der Informationen über das zu erzeugenden Layout auf der Metallbeschichtung des Keramik-Substrats an die Direktbelichtungsvorrichtung
- F5:: Erzeugen eines Datensatzes zu dem Metall-Keramik-Substrat ohne erste individualisierte Codierung
- F6:: Übermitteln der Informationen über das zu erzeugenden Layout auf der Metallbeschichtung des Keramik-Substrats an die Direktbelichtungsvorrichtung
- F7:: Belichtung der photosensitiven Schicht auf der einen Seite oder beiden Seiten der Metallbeschichtung zur Ausbildung des zu ätzenden Layouts mitsamt der zweiten individuellen Codierung
- F8:: Ätzen des unter F7 gebildeten Layouts zur Ausbildung des strukturierten Metall-Keramik-Substrates mitsamt der zweiten individuellen Codierung

Das erfindungsgemäße Verfahren geht aus von einem unstrukturierten Metall-Keramik-Substrat, welches bereits eine erste individualisierte Codierung (Route (a)) oder in einem nicht zur Erfindung gehörenden Verfahren keine erste individualisierte Codierung (Route (b)) aufweist.

Wenn das unstrukturierte Metall-Keramik-Substrat (Route (a)) eine erste individualisierte Codierung auf dem Keramik-Substrat aufweist, wird diese individualisierte erste Codierung durch eine Kamera eingelesen und erkannt (F2). Zu diesem Metall-Keramik-Substrat mit erster individualisierter Codierung liegt bereits ein Datensatz mit substratspezifischen Informationen, insbesondere mit Informationen über das zu erzeugende Layout vor. Die Informationen über das zu erzeugende Layout werden geladen (F3) und an die Direktbelichtungsvorrichtung, die einen Laser aufweist übermittelt (F4).

Wenn das unstrukturierte Metall-Keramik-Substrat (Route (b)) keine erste individualisierte Codierung auf dem Keramik-Substrat aufweist, wird ein Datensatz zu dem Metall-Keramik-Substrat in einer Datenbank erzeugt (F5) und Informationen zu dem erzeugenden Layout ergänzt (F6).

Im anschließenden Verfahrensschritt (F7) werden in beiden Routen (a) und (b) durch Direktbelichtung das Layout in der photosensitiven Schicht auf der Metallisierung erzeugt und in einem Ätzschritt das strukturierte Metall-Keramik-Substrat und die zweite individuelle Codierung erzeugt (F8).

Die Figur 2 zeigt unterschiedliche sichtbare Struktur, welche in die Metallbeschichtung mittels Direktbelichtung eingebracht werden können. Hierbei handelt es sich Strichcodes oder Datamatrix-Codes.

Das erfindungsgemäße Verfahren ermöglicht die individuelle Codierung von Metall-Keramik-Substraten. Darüber hinaus wird das Entfernen von fehlerhaften Bereichen in der Metallbeschichtung, wie beispielsweise mit von einem Lunker ermöglicht. Diese Lunker können beim Belichten ausgespart und somit weggeätzt werden. Alternativ können fehlerhafte Bauteile, welche solche Lunker aufweisen, markiert werden. Damit ist die fehlerhafte Stelle auf dem Metall-Keramik-Substrat oder alternativ das gesamte Metall-Keramik-Substrat eindeutig markiert. Weitere Vorteile der vorliegenden Erfindung ergeben sich durch die Abbildung von hochauflösenden Strukturen, die Vermeidung von Silber-Filmkosten sowie die Senkung von Ausschuss gegenüber konventionellen Belichtungsverfahren.

## Patentansprüche

1. Verfahren zur Herstellung von Metall-Keramik-Substraten, **gekennzeichnet durch** die folgenden Verfahrensschritte:
a. Bereitstellen eines unstrukturierten Metall-Keramik-Substrates, welches Metallbeschichtungen auf beiden Seiten des Keramiksubstrats aufweist, und welches eine erste individualisierte Codierung auf dem Keramik-Substrat aufweist;
b. Strukturieren der beidseitigen Metallbeschichtung des Metall-Keramik-Substrates;
c. Versehen des Metall-Keramik-Substrates mit einer zweiten individualisierten Codierung auf einer der Metallbeschichtungen oder auf beiden Metallbeschichtungen des Metall-Keramik-Substrats.

2. Verfahren nach Patentanspruch 1, **dadurch gekennzeichnet, dass** die erste individualisierte Codierung auf dem Keramik-Substrat eine optisch erkennbare Markierung ist, die auf dem unstrukturierten Keramik-Substrat vorzugsweise mit einem Farbstoff, beispielsweise einer Tinte, einer Metallpaste oder durch Markieren mittels Laser (unter Erzeugung einer optisch erkennbaren Codierung) erzeugt ist.

3. Verfahren nach Patentanspruch 1 oder 2, **dadurch gekennzeichnet, dass** eine Mehrzahl an Metall-Keramik-Substraten verwendet werden, die über einen Stützrand miteinander verbunden sind, der am Ende des Verfahrens verworfen wird, und die erste individualisierte Codierung auf dem Keramik-Substrat auf dem Stützrand vorgesehen ist.

4. Verfahren nach einem der Patentansprüche 1 bis 3, **dadurch gekennzeichnet, dass**
- die erste individualisierte Codierung auf dem Keramik-Substrat durch eine Kamera erfasst wird und
- zu der ersten individualisierten Codierung Informationen über der zu erzeugenden Strukturierung in Verfahrensschritt b. in einer Datenbank abgelegt werden oder abgelegt worden sind.

5. Verfahren nach Patentanspruch 4, **dadurch gekennzeichnet, dass** auf Basis der durch die Datenbank zu der ersten individualisierten Codierung auf dem Keramik-Substrat bereitgestellten Informationen in Verfahrensschritt b. eine Strukturierung beider Metallbeschichtungen des Metall-Keramik-Substrats erfolgt.

6. Verfahren nach einem der Patentansprüche 1 bis 5, **dadurch gekennzeichnet, dass** die Strukturierung des Metall-Keramik-Substrates im Verfahrensschritt b. durch Direktbelichtung erfolgt.

7. Verfahren nach einem der Patentansprüche 1 bis 6, **dadurch gekennzeichnet, dass** das Metall-Keramik-Substrat mit einer zweiten individualisierten Codierung auf eine oder auf beiden Metallbeschichtungen durch Direktbelichtung versehen wird.

8. Verfahren nach Patentanspruch 7, **dadurch gekennzeichnet, dass** im Fall, in welchem eine Mehrzahl an Metall-Keramik-Substraten verwendet werden, die über einen Stützrand miteinander verbunden sind, eine zweite individualisierte Codierung im Verfahrensschritt c. auf eine oder auf beiden Metallbeschichtungen eines jeden einzelnen Metall-Keramik-Substrats erzeugt wird, die einen identischen oder unterschiedlichen Informationsgehalt aufweisen können.

9. Verfahren nach einem der Patentansprüche 1 bis 8, **dadurch gekennzeichnet, dass** die erste individualisierte Codierung auf dem Keramik-Substrat und/oder die zweite individualisierte Codierung auf eine oder auf beiden Metallbeschichtungen als Strichcode, 2D-Code oder Datamatrix-Code ausgebildet ist und/oder dass die zweite individualisierte Codierung auf dem Keramik-Substrat aus einer freigeätzten beliebigen Fläche besteht, die fehlerhafte Einzelteile kennzeichnet.

10. Unstrukturiertes beidseitig metallbeschichtetes Metall-Keramik-Substrat mit einer auf das Keramik-Substrat aufgebrachten individuellen Codierung.

11. Beidseitig strukturiertes Metall-Keramik-Substrat mit einer auf eine oder auf beiden Metallbeschichtungen des Metall-Keramik-Substrats aufgebrachten Codierung.

12. Beidseitig strukturiertes Metall-Keramik-Substrat nach Patentanspruch 11, erhältlich nach dem Verfahren gemäß einem der Patenansprüche 1 bis 9.

## Claims

1. Process for the production of metal-ceramic substrates, **characterized by** the following process steps:
a. providing an unstructured metal-ceramic substrate having metal coatings on both sides of the ceramic substrate, and having a first individualized encoding on the ceramic substrate;
b. structuring the double-sided metal coating of the metal-ceramic substrate;
c. providing the metal-ceramic substrate with a second individualized coding on one of the metal coatings or on both metal coatings of the metal-ceramic substrate.

2. The method according to claim 1, **characterized in that** the first individualized coding on the ceramic substrate is an optically recognizable marking produced on the unstructured ceramic substrate preferably with a dye, for example an ink, a metal paste or by marking by means of a laser (producing an optically recognizable coding).

3. A method according to claim 1 or 2, **characterized in that** a plurality of metal-ceramic substrates are used, which are connected to each other via a support edge, which is discarded at the end of the method, and the first individualized coding on the ceramic substrate is provided on the support edge.

4. Method according to one of the claims 1 to 3, **characterized in that**
- the first individualized coding on the ceramic substrate is detected by a camera, and
- for the first individualized coding, information about the structuring to be generated in method step b. is stored or has been stored in a database.

5. Method according to claim 4, **characterized in that**, on the basis of the information provided by the database on the first individualized coding on the ceramic substrate, a structuring of both metal coatings of the metal-ceramic substrate is carried out in method step b.

6. Process according to one of the claims 1 to 5, **characterized in that** the structuring of the metal-ceramic substrate in process step b. is carried out by direct light exposure.

7. A process according to any one of claims 1 to 6, **characterized in that** the metal-ceramic substrate is provided with a second individualized coding on one or on both metal coatings by direct light exposure.

8. A method according to claim 7, **characterized in that** in the case where a plurality of metal-ceramic substrates are used which are connected to each other via a supporting edge, a second individualized coding is generated in process step c. on one or on both metal coatings of each individual metal-ceramic substrate, which may have an identical or different information content.

9. Method according to one of the patent claims 1 to 8, **characterized in that** the first individualized coding on the ceramic substrate and/or the second individualized coding on one or both metal coatings is formed as a bar code, 2D code or data matrix code and/or **in that** the second individualized coding on the ceramic substrate consists of a freely etched arbitrary area which identifies defective individual parts.

10. Unstructured metal-ceramic substrate coated on both sides with individual coding applied to the ceramic substrate.

11. Metal-ceramic substrate structured on both sides with coding applied to one or both metal coatings of the metal-ceramic substrate.

12. A double-sided patterned metal-ceramic substrate according to claim 11, obtainable by the process according to any one of claims 1 to 9.

## Revendications

1. Procédé de fabrication de substrats métal-céramique, **caractérisé par** les étapes de procédé suivantes :
a. Fournir un substrat métal-céramique non structuré, qui présente des revêtements métalliques sur les deux faces du substrat céramique, et qui présente un premier codage individualisé sur le substrat céramique ;
b. Structurer le revêtement métallique sur les deux faces du substrat métallo-céramique ;
c. Appliquer un deuxième codage individualisé sur l'un des revêtements métalliques ou sur les deux revêtements métalliques du substrat métal-céramique.

2. Procédé selon la revendication 1, **caractérisé en ce que** le premier codage individualisé sur le substrat céramique est un marquage optiquement reconnaissable, qui est produit sur le substrat céramique non structuré, de préférence avec un colorant, par exemple une encre, une pâte métallique ou par marquage au moyen d'un laser (en produisant un codage optiquement reconnaissable).

3. Procédé selon la revendication 1 ou 2, **caractérisé en ce qu'**on utilise une pluralité de substrats métal-céramique qui sont reliés entre eux par un bord de support qui est rejeté à la fin du procédé, et le premier codage individualisé est prévu sur le substrat céramique sur le bord de support.

4. Procédé selon l'une des revendications 1 à 3, **caractérisé en ce que**
- le premier codage individualisé sur le substrat en céramique est détecté par une caméra, et
- concernant le premier codage individualisé des informations quant à la structuration à générer sont ou ont été enregistrées dans une base de données à l'étape b. du procédé.

5. Procédé selon la revendication 4, **caractérisé en ce que**, sur la base des informations mises à disposition par la base de données concernant le premier codage individualisé sur le substrat céramique, une structuration des deux revêtements métalliques du substrat métal-céramique est effectuée dans l'étape b. du procédé.

6. Procédé selon l'une des revendications 1 à 5, **caractérisé en ce que** la structuration du substrat métal-céramique est effectuée dans l'étape b. du procédé par exposition directe.

7. Procédé selon l'une des revendications 1 à 6, **caractérisé en ce que** le substrat métal-céramique est pourvu d'un deuxième codage individualisé sur l'un ou sur les deux revêtements métalliques par exposition directe.

8. Procédé selon la revendication 7, **caractérisé en ce que**, dans le cas où l'on utilise une pluralité de substrats métal-céramique qui sont reliés entre eux par un bord de support, un deuxième codage individualisé est produit dans l'étape c. du procédé sur l'un ou sur les deux revêtements métalliques de chaque substrat métal-céramique individuel, qui peuvent présenter un contenu d'information identique ou différent.

9. Procédé selon l'une des revendications 1 à 8, **caractérisé en ce que** le premier codage individualisé sur le substrat en céramique et/ou le deuxième codage individualisé sur l'un ou sur les deux revêtements métalliques est réalisé sous la forme d'un code à barres, d'un code 2D ou d'un code Datamatrix et/ou **en ce que** le deuxième codage individualisé sur le substrat en céramique est constitué d'une surface quelconque gravée à l'acide qui identifie des pièces individuelles défectueuses.

10. Substrat métallo-céramique non structuré, revêtu de métal sur les deux faces, avec un codage individuel appliqué sur le substrat céramique.

11. Substrat métallo-céramique structuré sur les deux faces, avec un code appliqué sur l'un ou sur les deux revêtements métalliques du substrat métallo-céramique.

12. Substrat métallo-céramique structuré sur les deux faces selon la revendication 11, pouvant être obtenu par le procédé selon l'une des revendications 1 à 9.
